# EUROPEAN PATENT APPLICATION

(11) **EP 4 496 216 A1**
(43) Date of publication of application: **22.01.2025**
(21) Application number: 24170304.0
(22) Date of filing: 15.04.2024
(51) Int. Cl.: H02S 40/32, H02S 40/36, H02S 40/34

(54) **WIRING STRUCTURE AND PHOTOVOLTAIC SYSTEM**

(30) Priority: 18.07.2023 CN 202321898712 U
(71) Applicant: Sungrow (Shanghai) Co., Ltd., Shanghai 201203 (CN)
(72) Inventor: LI, Feng, Hefei, 230088 (CN); WEI, Shiyuan, Hefei, 230088 (CN); YU, Haiyang, Hefei, 230088 (CN)
(74) Representative: Rooney, John-Paul

(57) **Abstract**

A wiring structure and a photovoltaic system are provided in the present application. The wiring structure is used to electrically connect two electronic devices or to electrically connect one electronic device with an external circuit. The electronic device includes a housing and an electronic component located inside the housing.

## Description

The present application relates to the technical field of photovoltaic systems, and in particular to a wiring structure and a photovoltaic system.

### BACKGROUND

Generally, a photovoltaic system is provided with multiple electronic devices including an inverter. The multiple electronic devices are electrically connected. Therefore, the multiple electronic devices including the inverter are generally equipped with input terminals and output terminals. The input terminals are usually electrically connected to a junction box at a back side of a photovoltaic module, and the output terminals can be used for electrical connection of multiple electronic devices in series, or for electrical connection with a combiner box or with a power grid. The output terminals include a negative output terminal and a positive output terminal.

The positive electrode and negative electrode of the output terminal of the existing inverter are both mounted on a box by correspondingly opening on the box. The positive output terminal and the negative output terminal of a micro invert product are electrically connected by routing inside the box. If wires are routed inside the box, it may damage the components on the circuit board since the diameter of the wire is generally large and the wire is hard. It is necessary to provide corresponding support structures for supporting the wires and ensuring a safe distance from the corresponding components on the circuit board. The diameter of wire itself, the support structure and the safety distance may occupy a layout space of the circuit board inside the box, which increases the size and cost of electronic devices. In addition, wires routing inside the device may also have an impact on the EMC (electromagnetic compatibility) of the electronic devices.

### SUMMARY

A wiring structure is provided for facilitating the electronical connections between electronic devices, reducing the size and the cost of the electronic devices, and improving the EMC (electromagnetic compatibility) of the electronic devices.

The wiring structure provided according to the present application is used to electrically connect two electronic devices or to electrically connect one electronic device to an external circuit, each electronic device includes a housing and an electronic component located inside the housing, and the wiring structure comprises:
a first terminal provided on the housing and electrically connected to the electronic component; and
a second terminal having a quick-connecting terminal and an electrical connection module that are electrically connected to each other, and the quick-connecting terminal is connected to the first terminal, and the electrical connection module is configured to electrically connect the two electronic devices, or the one electronic device and the external circuit.

In one embodiment, the electrical connection module is a first wire, one end of the first wire is electrically connected to the quick-connecting terminal and the other end of the first wire is electrically connected to the external circuit.

In another embodiment, the electrical connection module comprises a positive output terminal and a negative output terminal, which are configured to electrically connect another electronic device or the external circuit.

In another embodiment, one of the positive output terminal and the negative output terminal is a male plug, and another of the positive output terminal and the negative output terminal is a female plug.

In another embodiment, at least two of the quick-connecting terminal, the positive output terminal, and the negative output terminal are electrically connected through a second wire.

In another embodiment, the wiring structure further comprises a third terminal, which includes a first adapter terminal and a second adapter terminal that are electrically connected with each other, the first adapter terminal is connected to the electrical connection module, and the second adapter terminal is connected to a second terminal of another wiring structure or to the external circuit.

In another embodiment, the first adapter terminal and the second adapter terminal are electrical connected with each other through a third wire.

In another embodiment, one of the first adapter terminal and the second adapter terminal is a male plug, and the other of the first adapter terminal and the second adapter terminal is a female plug, so as to adapt with the positive output terminal or the negative output terminal.

In another embodiment, one of the quick-connecting terminal and the first terminal is a male plug, and the other of the quick-connecting terminal and the first terminal is a female plug, and the quick-connecting terminal is fixed to the first terminal by plugging.

A photovoltaic system is further provided in the present application, which includes multiple electronic devices and the wiring structure as described above, and the wiring structure is electrically connected between two electronic devices or connected between one electronic device and an external circuit.

In one embodiment, the multiple electronic devices are connected in series.

In another embodiment, each electronic device includes a housing and electronic components located inside the housing, the housing includes a first housing portion and a second housing portion that are matched, the first housing portion is provided with a mounting notch, and the first housing portion and the second housing portion enclose to form a mounting hole , one end of the first terminal close to the electronic device is provided with a mounting portion, one of an inner periphery of the mounting hole and an outer periphery of the mounting portion is formed with a slot, the other of the inner periphery of the mounting hole and the outer periphery of the mounting portion is formed with an inserting portion, and the inserting portion can be inserted into the slot.

In the present application, the first terminal is provided on the housing and electrically connected to the electronic component, so that the first terminal is directly connected to the internal circuit. In addition, the first terminal is fixedly arranged, so that the internal circuit cannot move and thus the internal circuit board may not be damaged. Besides, the wire diameter of the internal circuit is small and the wire is short, which is beneficial to achieving miniaturization of device. The wiring structure further includes the second terminal, which includes the quick-connecting terminal, the positive output terminal, and the negative output terminal that are electrically connected to each other. The quick-connecting terminal is connected to the first terminal. When the two electronic devices are required to be electrically connected, the quick-connecting terminal is connected to the first terminal, so that the electronic device is electrically connected with the electrical connection module, and then the electrical connection module is connected to another electronic device. When the electronic device is required to be electrically connected to the external circuit, the electrical connection module can be directly connected to the external circuit, thereby completing the electrical connection of electronic devices. A part of the wire is externally arranged, and thus it not only facilitates miniaturization of electronic device, but also reduces impact of the internal routing of the wire on the EMC (electromagnetic compatibility) of electronic devices.

### BRIEF DESCRIPTION OF THE DRAWINGS

In order to describe the embodiments of the present application or the technical solutions in the prior art more clearly, a brief introduction will be given below to the accompanying drawings required for description of the embodiments or prior art. Obviously, the accompanying drawings in the following description are merely some embodiments of the present application. For those skilled in the art, other figures can be also obtained according to the structure shown in these figures without creative work.
FIG. 1 is a schematic structural view of a wiring structure according to an embodiment of the present application;
FIG 2 is a schematic structural view of a first terminal in the wiring structure shown in FIG. 1;
FIG. 3 is a schematic structural view of a second terminal in the wiring structure shown in FIG. 1;
FIG. 4 is a schematic structural view of a third terminal in the wiring structure shown in FIG. 1;
FIG. 5 is a schematic structural view of the second terminal in the wiring structure according to another embodiment of the present application;
FIG. 6 is a schematic structural view of a wiring structure according to another embodiment of the present application;
FIG. 7 is a schematic structural view of a photovoltaic system according to an embodiment of the present application;
FIG. 8 is a schematic structural view of electronic devices in the photovoltaic system of FIG. 6; and
FIG. 9 is a schematic structural view of a photovoltaic system according to another embodiment of the present application;

Reference numerals in the drawings are listed as follows:

| | | | |
|---|---|---|---|
| 100 | wiring structure; | 130 | third terminal; |
| 110 | first terminal; | 131 | first adaptor terminal; |
| 111 | mounting portion; | 132 | second adaptor terminal; |
| 112 | slot; | 133 | third wire; |
| 120 | second terminal; | 200 | electronic device; |
| 121 | quick-connecting terminal; | 210 | housing; |
| 122 | positive output terminal; | 211 | first housing portion; |
| 123 | negative output terminal; | 212 | second housing portion; |
| 124 | second wire; | 213 | mounting hole; |
| 125 | electrical connection module; | 214 | inserting portion; |
| 126 | first wire. | | |

The implementation, functions and advantages of the present application will be further explained in conjunction with embodiments and accompany drawings.

### DETAILED DESCRIPTION OF THE EMBODIMENTS

The technical solutions in the embodiments of the present utility mode will be described clearly and completely as follows in conjunction with the accompanying drawings in the embodiments of the present utility mode. It is apparent that the described embodiments are only a part of the embodiments according to the present utility mode, rather than all of the embodiments. All the other embodiments obtained by those skilled in the art based on the embodiments of the present utility mode without creative work will fall within the scope of protection of the present utility mode.

It should be understood that the orientation indications such as "up", "down", "left", "right", "front", and "back" are only used to explain the relative position relationship, the motion situation and so on under a specific posture, for example, shown in Figures. If the specific posture changes, those directional indications will change accordingly.

In addition, in the present application, the terms "first", "second" and the like are only for purpose of description, and should not be interpreted as indicating or implying relative importance or implying the number of the indicated technical features. Therefore, the features defined by "first" and "second" may explicitly or implicitly include one or more of the features. In addition, in the context of the present application, the "and/or" means that there can be three kinds of relationships, for example, A and/or B means that there are three cases: A alone, A and B at the same time, and B alone. In addition, the technical solutions among various embodiments can be combined with each other, provided that they must be based on what those skilled in the art in this field can achieve. When the combination of technical solutions conflicts or cannot be achieved, it should be considered that such combination of technical solutions does not exist and is not within the claimed protection scope of the present application.

A wiring structure 100 according to the present application is used for electrically connecting two electronic devices 200, or electrically connecting one electronic device 200 and an external circuit. The electronic device 200 includes a housing 210 and an electronic component located inside the housing 210.

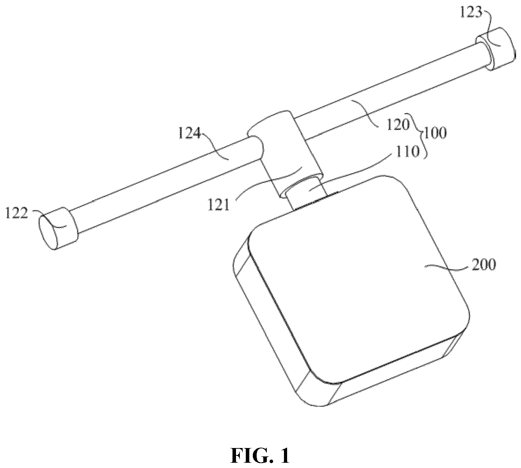

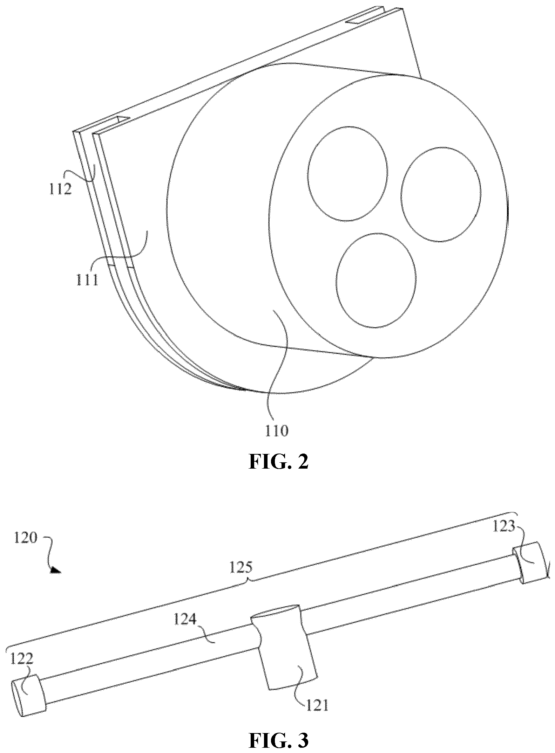

In an embodiment of the present application, as shown in FIGS. 1 to 9, the wiring structure 100 comprises a first terminal 110 and a second terminal 120. The first terminal 110 is provided on the housing 210 and electrically connected to the electronic component. The second terminal 120 includes a quick-connecting terminal 121 and an electrical connection module 125 that are electrically connected with each other. The quick-connecting terminal 121 is connected to the first terminal 110, and the electrical connection module 125 is electrically connected to the two electronic devices 200, or the one electronic device 200 and the external circuit.

Specifically, in a photovoltaic system, multiple electronic devices 200, such as an inverter, are electrically connected. Therefore, the electronic devices 200, such as an inverter, generally are equipped with input and output terminals. The input terminals are usually electrically connected to a junction box at a back side of the photovoltaic module. The output terminals may be used for electrical connecting multiple electronic devices 200 in series and may also be used for electrical connecting an external circuit, such as a combiner box or a power grid. Each output terminal includes a positive output terminal 122 and/or a negative output terminal 123. The positive output terminal 122 and/or the negative output terminal 123 of the existing inverter are both electrically connected to the electronic component inside the housing 210 through wires, and a mounting hole 213 is correspondingly provided in the housing 210. The positive output terminal 122 and/or the negative output terminal 123 pass through the mounting hole 213, and the wires can be extended or retracted according to the actual length of the connection. The remaining part of the wires is received inside the housing 210, that is, the wires need to be routed inside the housing 210. The diameters of wires are generally large and the wires are hard, which can damage the components on a circuit board, and thus it is necessary to provide a corresponding support structure for supporting the wires and ensuring a safe distance from the corresponding components on the circuit board. Due to the fact that the inverter used in photovoltaic systems is usually a micro inverter, the diameters of wires themselves, the support structure, and the safety distance may occupy the layout space of the circuit board inside the box, which greatly increases the size and the manufacturing cost of the inverter. Moreover, routing inside the equipment may also have an impact on the EMC (electromagnetic compatibility) of electronic devices 200.

In this embodiment, the first terminal 110 is provided on the housing 210 and electrically connected to the electronic component, so that the first terminal 110 is directly connected to the internal circuit. In addition, the first terminal 110 is fixedly arranged, so that the internal circuit cannot move and thus the internal circuit board may not be damaged. Besides, the wire diameter of the internal circuit is small and the wire is short, which is beneficial to achieving miniaturization of device. The wiring structure 100 further comprises a second terminal 120, which includes a quick-connecting terminal 121 and an electrical connection module 125 that are electrically connected with each other. The quick-connecting terminal 121 is connected to the first terminal 110. When two electronic devices 200 are required to be electrically connected, the quick-connecting terminal 121 is connected to the first terminal 110, so that one electronic device 200 is electrically connected with the electrical connection module 125, and then the electrical connection module 125 is connected to the other electronic device 200. When the electronic device 200 is electrically connected to the external circuit, the electrical connection module 125 can be directly connected to the external circuit, thereby completing the electrical connection of electronic devices 200. A part of the wire is externally arranged, and thus it not only facilitates miniaturization of electronic device 200, but also reduces impact of the internal routing of the wire on the EMC (electromagnetic compatibility) of electronic device 200.

Referring to FIGS. 1 to 5 and FIGS. 7 to 9, in case that multiple electronic devices 200 are connected in series, in an embodiment, the electrical connection module 125 includes a positive output terminal 122 and a negative output terminal 123, which are used for electrical connection with another electronic device 200 or the external circuit. Specifically, when two middle-positioned electronic devices 200 among multiple electronic devices 200 (both ends of each of these two middle-positioned electronic device 200 are connected to adjacent electronic device 200, respectively) are required to be electrically connected, the quick-connecting terminal 121 is connected to the first terminal 110, so that the electronic component is electrically connected with both the positive output terminal 122 and the negative output terminal 123, and then the positive output terminal 122 is connected to a negative output terminal 123 of another electronic device 200. When an electronic device 200 at the end among multiple electronic devices 200 (one end of this electronic device 200 is connected to the external circuit) is required to be electrically connected, the positive output terminal 122 of one of the two second terminals 120 (located at two ends of the circuit) or the negative output terminal 123 of the other of the two second terminals 120 is connected to the external circuit, respectively, thereby completing the electrical connection of the electronic device 200.

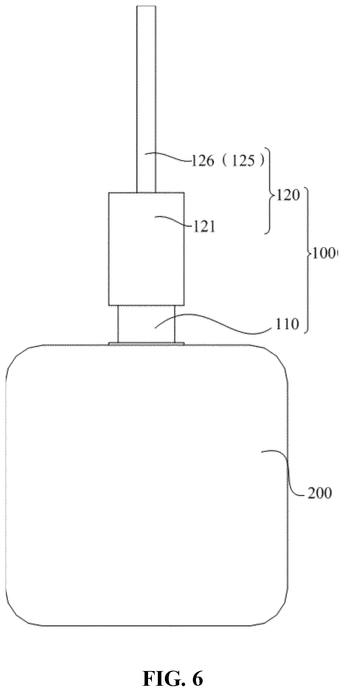

Referring to FIG. 6, in case that multiple electronic devices 200 are not required to be connected in series, in an embodiment, the electrical connection module 125 is a first wire 126, with one end being electrically connected to the quick-connecting terminal 121 and the other end being electrically connected the external circuit. Specifically, the electronic device 200 is directly connected to the external circuit and has no direct electrical connection with other electronic devices 200. In this case, the electrical connection module 125 is the first wire 126, and one end of the first wire 126 away from the quick-connecting terminal 121 can also be a terminal adapted to the external circuit, thereby facilitating the connection between the electronic device 200 and the external circuit.

In an embodiment, referring to FIGS. 1 to 5 and FIGS. 7 to 9 again, one of the quick-connecting terminal 121 and the first terminal 110 is a male plug, and the other of the quick-connecting terminal 121 and the first terminal 110 is a female plug. The quick-connecting terminal 121 is fixed to the first terminal 110 by plugging so as to improve the compatibility between the quick-connecting terminal 121 and the first terminal 110. By plugging and unplugging the first terminal 110, the quick-connecting terminal 121 and the first terminal 110 can be electronically connected, facilitating the electrical connection between the quick connect terminal 121 and the first terminal 110. Herein, one of the quick-connecting terminal 121 and the first terminal 110 is a male plug, and the other of the quick-connecting terminal 121 and the first terminal 110 is a female plug, that is, the quick-connecting terminal 121 can be a male plug and the first terminal 110 can be a female plug, alternatively, the first terminal 110 can be a male plug and the quick-connecting terminal 121 can be a female plug.

In another embodiment, one of the positive output terminal 122 and the negative output terminal 123 is a male plug, and the other of the positive output terminal 122 and the negative output terminal 123 is a female plug. Specifically, on one hand, the adaptability between the second terminal 120 and the external circuit is improved, so that the second terminal 120 always has an adaptive wiring terminal regardless that the external circuit is equipped with a male plug or a female plug, and on the other hand, the adaptability between the two second terminals 120 that are in the electrical connection is improved, and the electrical connection between these two second terminals 120 can be achieved without an adapter. Herein, one of the positive output terminal 122 and the negative output terminal 123 can be a male plug and the other of the positive output terminal 122 and the negative output terminal 123 can be a female plug. That is, the positive output terminal 122 can be a male plug and the negative output terminal 123 can be a female plug, alternatively, the positive output terminal 123 can be a male plug and the negative output terminal 122 can be a female plug.

In the present application, the first terminal 110 is located on the housing 210 and is electrically connected to the electronic component, so that the first terminal 110 is directly connected to the internal circuit, and the first terminal 110 is fixedly arranged. Therefore, the internal circuit cannot move and thus the internal circuit board may not be damaged. In addition, the diameter of the wire of the internal circuit is small and the wire is short, which is beneficial to achieving equipment miniaturization. The wiring structure 100 further includes the second terminal 120. The second terminal 120 includes the quick-connecting terminal 121, the positive output terminal 122, and the negative output terminal 123 that are electrically connected with each other. The quick-connecting terminal 121 is connected to the first terminal 110. When requiring for electrically connecting two electronic devices 200, the quick-connecting terminal 121 is connected to the first terminal 110, so that one electronic device 200 is electronically connected to the electrical connection module 125, and then the electrical connection module 125 is connected to another electronic device 200. When the electronic device 200 is required to be connected to the external circuit, the electrical connection module 125 can be directly connected to the external circuit, thereby completing the electrical connection of electronic devices 200. A part of the wire is externally arranged, and thus it not only facilitates miniaturization of electronic device 200, but also reduces impact of the internal routing of the wire may apply on the EMC (electromagnetic compatibility) of electronic devices 200.

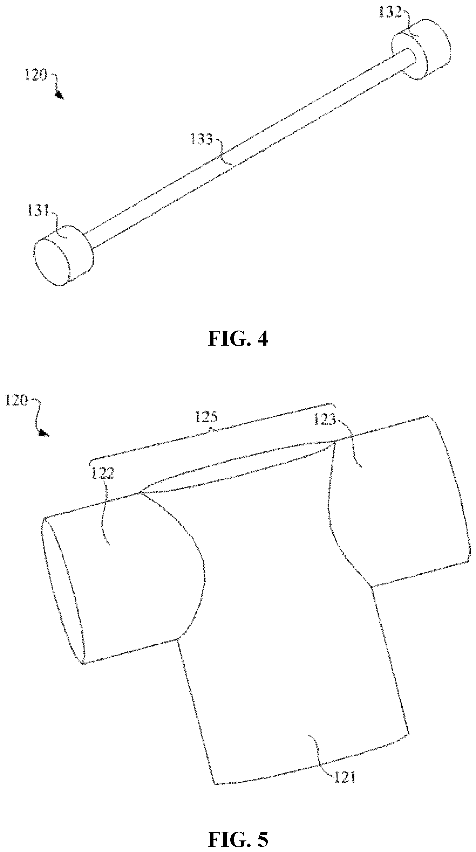

Referring to FIGS. 1, 3, and 7, in an embodiment, at least two of the quick-connecting terminal 121, the positive output terminal 122, and the negative output terminal 123 are electrically connected through a second wire 124. Specifically, by providing the second wire 124, the distances between the quick-connecting terminal 121, the positive output terminal 122 and the negative output terminal 123 are lengthened, allowing the users to connect two electronic devices 200 according to actual conditions and avoid the situation where the circuit cannot be connected properly due to the small length of the second wire 124. Specifically, at least two of the quick-connecting terminal 121, the positive output terminal 122, and the negative output terminal 123 are electrically connected through the second wire 124, that is, the second wire 124 can be connected only between any two of the quick-connecting terminal 121, the positive output terminal 122, and the negative output terminal 123, or connected between all the quick-connecting terminal 121, the positive output terminal 122, and the negative output terminal 123. Of course, in other embodiments, referring to FIG. 5, the second wire 124 is not provided among the quick-connecting terminal 121, the positive output terminal 122, and the negative output terminal 123.

In case that the second wire 124 is not provided among the quick-connecting terminal 121, the positive output terminal 122, and the negative output terminal 123, in an embodiment, referring to FIGS. 4, 5, and 9, the wiring structure 100 further includes a third terminal 130, which includes a first adapter terminal 131 and a second adapter terminal 132 that are electrically connected. The first adapter terminal 131 is connected to the electrical connection module 125, and the second adapter terminal 132 is connected to another second terminal 120 or to the external circuit. Specifically, if a second wire 124 is not provided among the quick-connecting terminal 121, the positive output terminal 122, and the negative output terminal 123, in order to ensure a reliable connection between the two electronic devices 200, a third terminal 130 is required to extend the length of the second terminal 120, thereby avoiding the situation where the circuit cannot be connected normally due to a too short length of the wire. The third terminal 130 can also be electrically connected to the first wire 126, thereby extending the first wire 126 or facilitating the connection between the first wire 126 and the external circuit.

Furthermore, the first adapter terminal 131 and the second adapter terminal 132 are electrically connected through the third wire 133. The length of the third wire 133 can be various, which further facilitates the users to connect two electronic devices 200 according to actual mounting conditions. Therefore, it further reduces the situation where the circuit cannot be connected properly due to the too short length of the third wire 133.

In an embodiment, one of the first adapter terminal 131 and the second adapter terminal 132 is a male plug and the other of the first adapter terminal 131 and the second adapter terminal 132 is a female plug, so as to be adapted to the positive output terminal 122 or negative output terminal 123. Specifically, in order to improve the compatibility between the third terminal 130 and the second terminal 120, no matter that the positive output terminal 122 or negative output terminal 123 is a male or female plug, the third terminal 130 has a first adapter terminal 131 and a second adapter terminal 132 that are compatible with them, and thus the electrical connection between the third terminal 130 and the second terminal 120 can be achieved without an adapter. Specifically, one of the first adapter terminal 131 and the second adapter terminal 132 is a male plug, and the other of the first adapter terminal 131 and the second adapter terminal 132 is a female plug, that is, the first adapter terminal 131 can be a male plug and the second adapter terminal 132 can be a female plug, alternatively, the second adapter terminal 132 can be a male plug and the first adapter terminal 131 can be a female plug.

The present application further provides a photovoltaic system, which includes multiple electronic devices 200 and the wiring structure 100. The specific structure of the wiring structure 100 can make reference to the above embodiments. As the photovoltaic system adopts all the technical solutions of the above embodiments, it has at least all the beneficial effects brought by the technical solutions of the above embodiments, and is not repeated here. Specifically, the wiring structure 100 is connected between two electronic devices 200, or between the electronic device 200 and the external circuit.

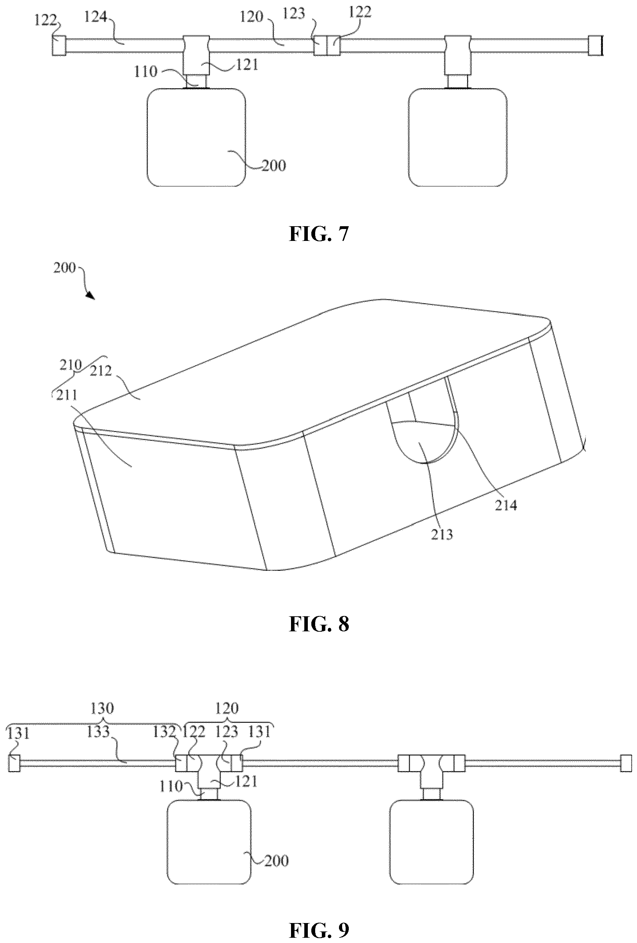

Furthermore, referring to FIGS. 7 and 9, multiple electronic devices 200 are connected in series to achieve electrical connection of these electronic devices 200.

In an embodiment, the electronic device 200 includes the housing 210 and electronic components located inside the housing 210. The housing 210 includes the first housing portion 211 and the second housing portion 212 that are mutually covered. The first housing portion 211 is provided with the mounting notch, and the first housing portion 211 and the second housing portion 212 enclose to form the mounting hole 213. One end of the first terminal 110 close to the electronic device 200 has a mounting portion 111. One of an inner periphery of the mounting hole 213 and an outer periphery of the mounting portion 111 is formed with a slot 112 and the other of the inner periphery of the mounting hole 213 and the outer periphery of the mounting portion 111 is formed with an insertion part 214, which can be inserted into the slot 112. Specifically, the first terminal 110 is fixed to the housing 210 by insertion, which, on one hand, facilitates mounting the first terminal 110 with the housing 210 and facilitates maintenance and the replacement for the first terminal 110, and, on the other hand, reduces the possibility of water or dust accidentally entering the interior of the housing 210 through the mounting hole 213.

The description above is only preferable embodiments of the present application which are not intend to limit the scope of the present application. Any equivalent structural variations made under the invention concept of this present application and with the description and drawings thereof, or directly/indirectly application in other related technical fields are all fallen into the protection scope of the present application.

## Claims

1. A wiring structure for electrically connecting two electronic devices or electrically connecting one electronic device to an external circuit, wherein each of two electronic devices comprises a housing and an electronic component located inside the housing,
wherein the wiring structure comprises:
a first terminal, which is provided on the housing and electrically connected to the electronic component; and
a second terminal, which comprises a quick-connecting terminal and an electrical connection module that are electrically connected to each other,
wherein the quick-connecting terminal is connected to the first terminal, and the electrical connection module is configured to electrically connect the two electronic devices, or the one electronic device and the external circuit.

2. The wiring structure according to claim 1, wherein the electrical connection module is a first wire, one end of the first wire is electrically connected to the quick-connecting terminal and another end of the first wire is electrically connected to the external circuit.

3. The wiring structure according to claim 1, wherein the electrical connection module comprises a positive output terminal and a negative output terminal, which are configured to electrically connect another electronic device or the external circuit.

4. The wiring structure according to claim 3, wherein one of the positive output terminal and the negative output terminal is a male plug, and the other of the positive output terminal and the negative output terminal is a female plug.

5. The wiring structure according to claim 3, wherein at least two of the quick-connecting terminal, the positive output terminal, and the negative output terminal are electrically connected through a second wire.

6. The wiring structure according to claim 1, wherein the wiring structure further comprises a third terminal, which comprises a first adapter terminal and a second adapter terminal that are electrically connected with each other,
wherein the first adapter terminal is connected to the electrical connection module, and the second adapter terminal is connected to a second terminal of another wiring structure or to the external circuit.

7. The wiring structure according to claim 6, wherein the first adapter terminal and the second adapter terminal are electrically connected with each other through a third wire.

8. The wiring structure according to claim 6, wherein one of the first adapter terminal and the second adapter terminal is a male plug, and another of the first adapter terminal and the second adapter terminal is a female plug.

9. The wiring structure according to any one of claims 1 to 8, wherein one of the quick-connecting terminal and the first terminal is a male plug, and another of the quick-connecting terminal and the first terminal is a female plug,
wherein the quick-connecting terminal is fixed to the first terminal by plugging.

10. A photovoltaic system, comprising a plurality of electronic devices and the wiring structure according to any one of claims 1 to 9, wherein the wiring structure is electrically connected between two of the plurality of electronic devices or connected between one of the plurality of electronic devices and the external circuit.

11. The photovoltaic system according to claim 10, wherein the plurality of electronic devices 200 are connected in series.

12. The photovoltaic system according to claim 10, wherein each of the plurality of electronic device comprises a housing and an electronic component located inside the housing,
wherein the housing comprises a first housing portion and a second housing portion that are matched, the first housing portion is provided with a mounting notch and, the first housing portion and the second housing portion together enclose to form a mounting hole,
wherein one end of the first terminal close to the electronic device is provided with a mounting portion, one of an inner periphery of the mounting hole and an outer periphery of the mounting portion is formed with a slot and another of the inner periphery of the mounting hole and the outer periphery of the mounting portion is formed with an inserting portion, and the inserting portion is inserted into the slot.
